# EUROPEAN PATENT APPLICATION

(11) **EP 4 797 441 A1**
(43) Date of publication of application: **26.08.2026**
(21) Application number: 25188049.8
(22) Date of filing: 08.07.2025
(51) Int. Cl.: H01Q 1/24, H01Q 1/38, H01Q 9/04, H01Q 9/06

(54) **ELECTRONIC DEVICE**

(30) Priority: 21.02.2025 CN 202510195238
(71) Applicant: Getac Technology Corporation, New Taipei City 221009 (TW)
(72) Inventor: TSAI, Ying-Chieh, 11568 Taipei City (TW)
(74) Representative: Viering, Jentschura & Partner mbB Patent- und Rechtsanwälte

(57) **Abstract**

The present disclosure provides an electronic device, which includes a circuit board and an antenna signal processing device. A metal layer of an upper surface of the circuit board forms at least one printed antenna. The antenna signal processing device is mounted on the circuit board. The antenna signal processing device is electrically connected to the at least one printed antenna through the circuit board.

## Description

### BACKGROUND

### Field of Invention

The present invention relates to hardware devices, and more particularly, electronic devices.

### Description of Related Art

Generally, when developing and designing laptops and tablet computers, multiple antennas are usually required to support different frequency bands and standards. Multiple antenna designs mean that more space is needed to plan the antenna positions and cable paths. During the design process, product quality is often sacrificed due to insufficient antenna and cable management space; too many cables also cause messy cable management, reduce assembly efficiency and increase design costs.

In view of the foregoing, these antenna designs have some deficiencies that await further improvements. However, those skilled in the art sought vainly for a solution. Accordingly, there is an urgent need in the related field to increase assembly efficiency.

### SUMMARY

In one or more various aspects, the present disclosure is directed to electronic devices to solve the problems of the prior art.

Some embodiments of the present disclosure is related to an electronic device including a circuit board and an antenna signal processing device. A metal layer of an upper surface of the circuit board forms at least one printed antenna. The antenna signal processing device is mounted on the circuit board, and the antenna signal processing device is electrically connected to the at least one printed antenna through the circuit board.

In some embodiments of the present disclosure, the at least one printed antenna includes a first printed antenna and a second printed antenna. The first printed antenna is formed on the upper surface of the circuit board. The second printed antenna is formed on the upper surface of the circuit board, where the first printed antenna and the second printed antenna are positioned at opposite sides of the antenna signal processing device.

In some embodiments of the present disclosure, the first printed antenna is physically connected to one side of the antenna signal processing device via a first printed wiring printed on the upper surface of the circuit board, and the second printed antenna is physically connected to another side of the antenna signal processing device via a second printed wiring printed on the upper surface of the circuit board.

In some embodiments of the present disclosure, the circuit board is a main board, the main board is divided into a main circuit area and an extension area, and the at least one printed antenna is formed on the extension area.

In some embodiments of the present disclosure, the electronic device further includes a housing, where the main board is disposed on the housing, and a distance between the extension area of the main board and a border of the housing is shorter than a distance between the main circuit area of the main board and the border of the housing.

In some embodiments of the present disclosure, the circuit board is a RF (radio frequency) switch board, and the at least one printed antenna is formed on the RF switch board.

In some embodiments of the present disclosure, the electronic device further includes a main board. The main board is electrically connected to the RF switch board, and the RF switch board is disposed on the main board.

Some embodiments of the present disclosure is related to an electronic device including a circuit board and an antenna signal processing device. The circuit board includes a first printed circuit board, where a first metal layer of an upper surface of the first printed circuit board forms at least one printed antenna. The antenna signal processing device is mounted on the first printed circuit board, and the antenna signal processing device is electrically connected to the at least one printed antenna through the first metal layer.

In some embodiments of the present disclosure, the first printed circuit board is divided into a main circuit area and an extension area, a portion of the first metal layer of the upper surface of the first printed circuit board is located within the extension area to form the at least one printed antenna, and another portion of the first metal layer of the upper surface of the first printed circuit board is located within the main circuit area to form a printed circuit.

In some embodiments of the present disclosure, the circuit board further includes a second printed circuit board. The second printed circuit board is disposed below the first printed circuit board, a main circuit area of the second printed circuit board directly faces the main circuit area of the first printed circuit board, an extension area of the second printed circuit board directly faces the extension area of the first printed circuit board, and a second metal layer of the upper surface of the second printed circuit board is disposed within the main circuit area of the second printed circuit board only and does not extend to the extension area of the second printed circuit board.

**In** some embodiments of the present disclosure, the printed circuit formed by the portion of the first metal layer of the upper surface of the first printed circuit board within the main circuit area is used to transmit signals, and the second metal layer of the upper surface of the second printed circuit board serves as a ground layer.

In some embodiments of the present disclosure, the circuit board is a main board, the main board is divided into a main circuit area and an extension area, and the at least one printed antenna is formed in the extension area.

In some embodiments of the present disclosure, the electronic device further includes a housing, where the main board is disposed on the housing, and a distance between the extension area of the main board and a border of the housing is shorter than a distance between the main circuit area of the main board and the border of the housing.

In some embodiments of the present disclosure, the circuit board is a **RF** (radio frequency) switch board, and the at least one printed antenna is formed on the RF switch board.

In some embodiments of the present disclosure, the electronic device further includes a main board. The main board is electrically connected to the RF switch board, and the RF switch board is disposed on the main board.

Technical advantages generally achieved by embodiments of the present disclosure include, by designing the printed antenna on the circuit board in the electronic device of the present disclosure, the risk of excess inventory can be reduced, the assembly efficiency can be increased, and the cost reduction effect can be achieved.

Many of the attendant features will be more readily appreciated, as the same becomes better understood by reference to the following detailed description considered in connection with the accompanying drawings.

### BRIEF DESCRIPTION OF THE DRAWINGS

The invention can be more fully understood by reading the following detailed description of the embodiment, with reference made to the accompanying drawings as follows:
Fig. 1 is a plan view of an electronic device according to some embodiments of the present disclosure;
Fig. 2 is a plan view of an electronic device according to some embodiments of the present disclosure; and
Fig. 3 is a cross-sectional view of the electronic device according to some embodiments of the present disclosure.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

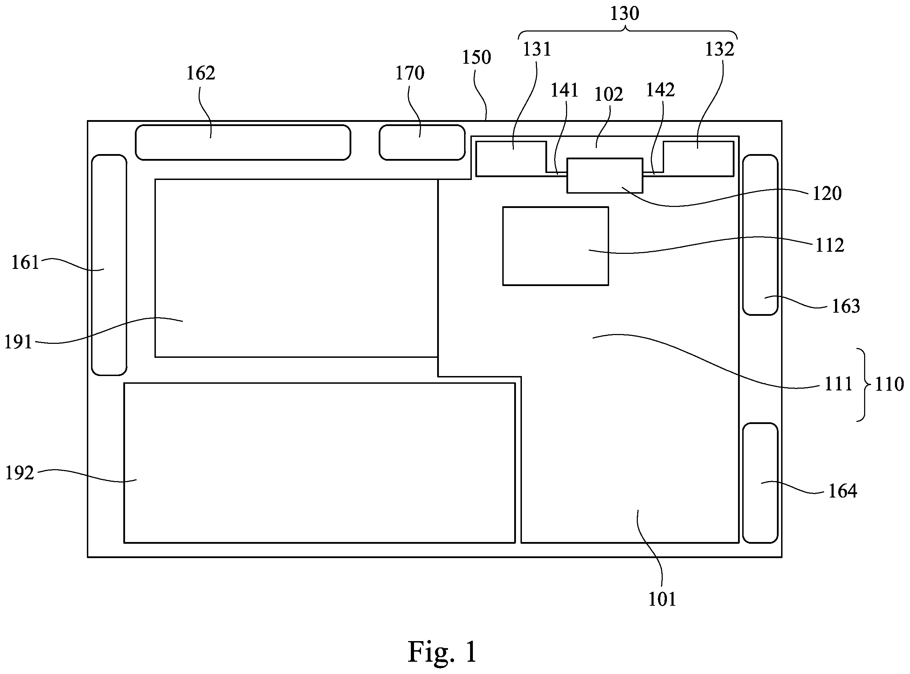

Referring to Fig. 1, Fig. 2 and Fig. 3, in one aspect, the present disclosure is directed to electronic devices. The electronic devices can be applied to various electronic products with wireless communication functions and may be applicable or readily adaptable to all technologies. Accordingly, the electronic devices have advantages. Herewith the electronic devices are described below with Fig. 1, Fig. 2 and Fig. 3.

The subject disclosure provides the electronic devices in accordance with the subject technology. Various aspects of the present technology are described with reference to Fig. 1, Fig. 2 and Fig. 3. In the following description, for purposes of explanation, numerous specific details are set forth in order to provide a thorough understanding of one or more aspects. It can be evident, however, that the present technology can be practiced without these specific details. In other instances, well-known structures and devices are shown in block diagram form in order to facilitate describing these aspects. The word "exemplary" is used herein to mean "serving as an example, instance, or illustration." Any embodiment described herein as "exemplary" is not necessarily to be construed as preferred or advantageous over other embodiments.

Referring to Fig. 1, Fig. 1 is a plan view of an electronic device according to some embodiments of the present disclosure. In practice, for example, the electronic device can be applied to a screen, a mobile phone, a tablet or another electronic product.

As shown in Fig. 1, the electronic device includes a circuit board 110 and an antenna signal processing device 120. In practice, for example, the antenna signal processing device 120 can be an antenna signal processing circuit, an antenna signal solution chip or other similar circuits, but the present disclosure is not limited thereto.

In structure, the metal layer of the upper surface of the circuit board 110 forms the printed antenna 130, the antenna signal processing device 120 is mounted on the circuit board 110, and the antenna signal processing device 120 is electrically connected to the printed antenna 130 through the circuit board 110. By designing the printed antenna 130 on the circuit board 110 in the electronic device of the present disclosure, the risk of stock preparation can be reduced, the assembly efficiency can be increased, and the cost reduction effect can be achieved.

It should be understood that, in this disclosure, the description of "electrical connection" can generally refer to one component being indirectly electrically coupled to another component through other components, or one component being directly electrically connected to another component without going through another component. For example, the printed antenna 130 may be directly physically connected to the antenna signal processing device 120, or the printed antenna 130 may be indirectly electrically coupled to the antenna signal processing device 120 via the printed wiring.

In some embodiments of the present disclosure, the printed antenna 130 includes a first printed antenna 131 and a second printed antenna 132. In practice, for example, the first printed antenna 131 can be a first Wi-Fi antenna, and the second printed antenna 132 can be a second Wi-Fi antenna, and they may support different frequency bands and/or standards respectively.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the embodiments.

In structure, the first printed antenna 131 is formed on the upper surface of the circuit board 110, and the second printed antenna 132 is formed on the upper surface of the circuit board 110. The first printed antenna 131 and the second printed antenna 132 are respectively positioned at opposite sides of the antenna signal processing device 120 to avoid the mutual interference between the first printed antenna 131 and the second printed antenna 132.

In some embodiments of the present disclosure, the first printed antenna 131 is physically connected to one side of the antenna signal processing device 120 via the first printed wiring 141 printed on the upper surface of the circuit board 110, and the second printed antenna 132 is physically connected to another side of the antenna signal processing device 120 via the second printed wiring 142 printed on the upper surface of the circuit board 110. By printing the first printed wiring 141 and the second printed wiring 142 on the upper surface of the circuit board 110, there is no need for additional cables which causes messy cable management.

In some embodiments of the present disclosure, the circuit board 110 is the main board 111, the printed antenna 130 is designed on the main board 111, and thus the risk of stock preparation can be reduced, the assembly efficiency can be increased, and the cost reduction effect can be achieved. The main board 111 is divided into a main circuit area 101 and an extension area 102, and the printed antenna 130 is formed in the extension area 102. Since the printed antenna 130 is formed on the extension area 102, and therefore the printed antenna 130 does not need to occupy the main circuit area 101.

In some embodiments of the present disclosure, the electronic device further includes a housing 150. In structure, the main board 111 is disposed on the housing 150, and a distance between the extension area 102 of the main board 111 and a border of the housing 150 is shorter than a distance between the main circuit area 101 of the main board 111 and the border of the housing 150, thereby eliminating the need to use the space of the main circuit area 101 of the main board 111 to plan the position of the printed antenna 130.

In Fig. 1, the camera hardware module 170 and the antenna hardware modules 161-164 are respectively disposed near the border of the housing 150. In practice, for example, the antenna hardware module 161 can be a main antenna of a wireless wide area network (WWAN), the antenna hardware module 162 can include an antenna of a global navigation satellite system (GNSS) and an antenna of multi-input multi-output (MIMO), the antenna hardware module 163 can be an auxiliary antenna of the wireless wide area network, and the antenna hardware module 164 can be an antenna of multi-input multi-output, but the present disclosure is not limited thereto.

In other embodiments, at least one of the antenna hardware modules 161-164 can also be implemented as at least one printed antenna formed in the extension area 102 of the main board 111, but the present disclosure is not limited thereto.

In Fig. 1, the batteries 191 and 192 are disposed beside the main board 111, and the RF switch board 112 is disposed on the main board 111. In practice, for example, the RF switch board 112 is used to switch the path between the built-in antenna (e.g., the printed antenna 130, the antenna hardware modules 161-164, etc.) and one or more external antennas (not shown), but the present disclosure is not limited thereto.

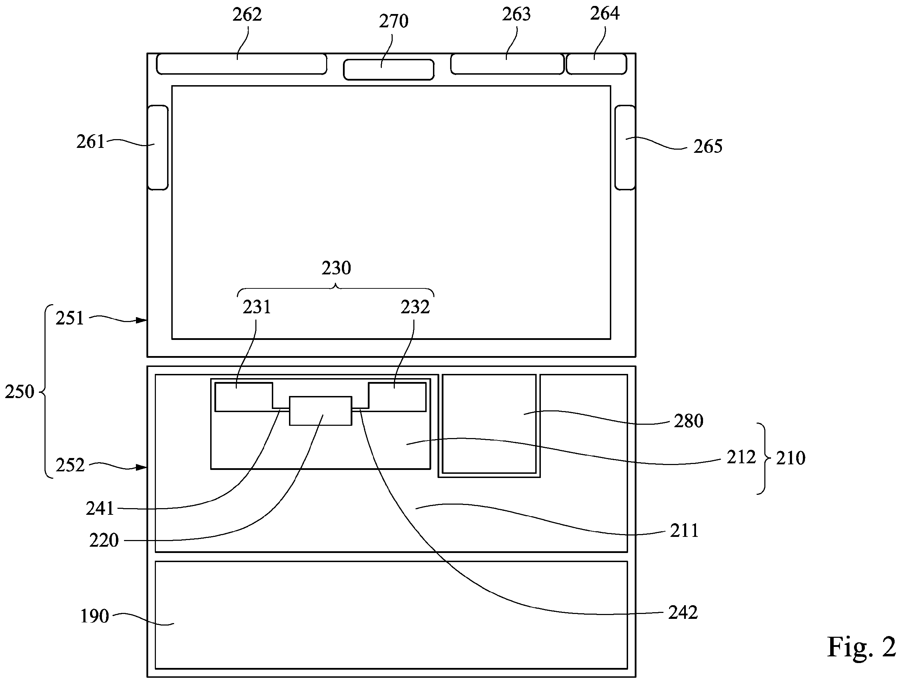

Referring to Fig. 2, Fig. 2 is a plan view of an electronic device according to some embodiments of the present disclosure. In practice, for example, the electronic device can be applied to a mobile phone, a laptop or another electronic product.

As shown in Fig. 2, the electronic device includes a circuit board 210 and an antenna signal processing device 220. In practice, for example, the antenna signal processing device 220 can be an antenna signal processing circuit, an antenna signal solution chip or other similar circuits, but the present disclosure is not limited thereto.

In structure, the metal layer of the upper surface of the circuit board 210 forms the printed antenna 230, the antenna signal processing device 220 is mounted on the circuit board 210, and the antenna signal processing device 220 is electrically connected to the printed antenna 230 through the circuit board 210. By designing the printed antenna 230 on the circuit board 210 in the electronic device of the present disclosure, the risk of stock preparation can be reduced, the assembly efficiency can be increased, and the cost reduction effect can be achieved.

In some embodiments of the present disclosure, the printed antenna 230 includes a first printed antenna 231 and a second printed antenna 232. In practice, for example, the first printed antenna 231 can be a first Wi-Fi antenna, and the second printed antenna 232 can be a second Wi-Fi antenna, and they may support different frequency bands and/or standards respectively.

In structure, the first printed antenna 231 is formed on the upper surface of the circuit board 210, and the second printed antenna 232 is formed on the upper surface of the circuit board 210. The first printed antenna 231 and the second printed antenna 232 are respectively positioned at opposite sides of the antenna signal processing device 220 to avoid the mutual interference between the first printed antenna 231 and the second printed antenna 232.

In some embodiments of the present disclosure, the first printed antenna 231 is physically connected to one side of the antenna signal processing device 220 via the first printed wiring 241 printed on the upper surface of the circuit board 210, and the second printed antenna 232 is physically connected to another side of the antenna signal processing device 220 via the second printed wiring 242 printed on the upper surface of the circuit board 210. By printing the first printed wiring 241 and the second printed wiring 242 on the upper surface of the circuit board 210, there is no need for additional cables which causes messy cable management.

In some embodiments of the present disclosure, the circuit board 210 is the RF (radio frequency) switch board 212, and the printed antenna 230 is formed on the RF switch board 212. The printed antenna 230 is printed on the RF switch board 212, and thus the risk of stock preparation can be reduced, the assembly efficiency can be increased, and the cost reduction effect can be achieved. In addition, the integrated design as to the printed antenna 230 printed on the RF switch board 212 can simplify the assembly difficulty and design complexity.

In some embodiments of the present disclosure, the electronic device further includes a main board 211. In structure, the main board 211 is electrically connected to the RF switch board 212, and the RF switch board 212 is disposed on the main board 211 to reduce the overall area.

In FIG. 2, the housing 250 includes a screen housing 251 and a host housing 252, and the screen housing 251 and the host housing 252 are pivotally connected to each other. In structure, the main board 211, the heat dissipation hardware module 280 and the battery 190 are disposed on the host housing 252, and the printed antenna 230 is disposed near a border of the host housing 252.

In Fig. 2, the camera hardware module 270 and the antenna hardware modules 261-265 are respectively disposed near a border of the screen housing 251. In practice, for example, the antenna hardware module 261 can be an antenna of multi-input multi-output, the antenna hardware module 262 can be a main antenna of the wireless wide area network, the antenna hardware module 263 can be an auxiliary antenna of the wireless wide area network, the antenna hardware module 264 can be an antenna of the global navigation satellite system, and the antenna hardware module 265 may be an antenna of multi-input multi-output, but the present disclosure is not limited thereto.

In Fig. 2, in practice, for example, the RF switch board 112 is used to switch the path between the built-in antenna (e.g., the printed antenna 230, the antenna hardware modules 261-265, etc.) and one or more external antennas (not shown), but the present disclosure is not limited thereto.

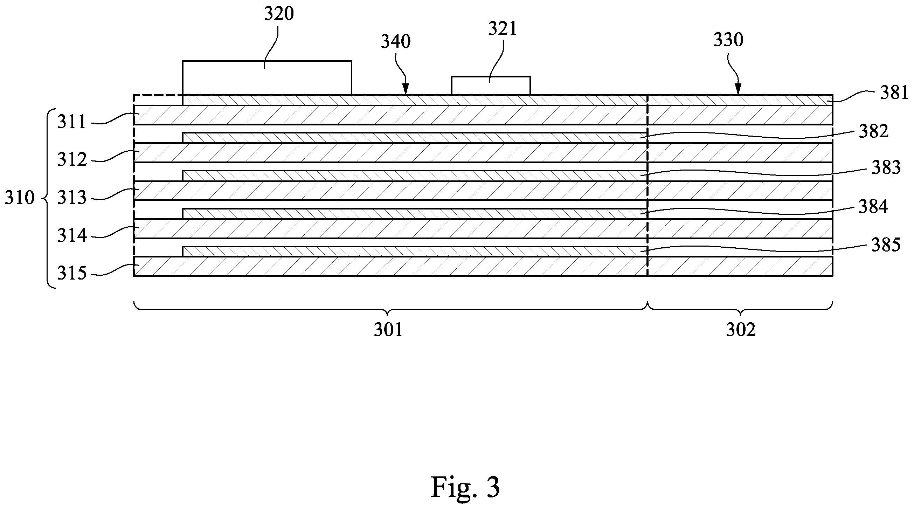

Fig. 3 is a cross-sectional view of the electronic device according to some embodiments of the present disclosure. As shown in Fig. 3, the electronic device includes a circuit board 310 and an antenna signal processing device 320. In structure, the circuit board 310 includes a first printed circuit board 311, and the first metal layer 381 of the upper surface of the first printed circuit board 311 forms a printed antenna 330. The antenna signal processing device 320 is mounted on the first printed circuit board 311. The antenna signal processing device 320 is electrically connected to the printed antenna 330 through the first metal layer 381, without the need for additional cables which causes messy cable management.

In some embodiments of the present disclosure, the first printed circuit board 311 is divided into a main circuit area 301 and an extension area 302, a portion of the first metal layer 381 of the upper surface of the first printed circuit board 311 is located within the extension area 302 to form the printed antenna 330, and another portion of the first metal layer 381 of the upper surface of the first printed circuit board 311 is located within the main circuit area 301 to form the printed circuit 340.

**In** practice, for example, the matching circuit 321 is electrically connected between the antenna signal processing device 320 and the printed antenna 330, and the printed antenna 330 is electrically connected to the antenna signal processing device 320 and the matching circuit 321 through the printed circuit 340, without the need for additional cables which causes messy cable management. **In** addition, the printed antenna 330 is formed on the extension area 302 of the first printed circuit board 311, and no additional antenna holder is required.

**In** some embodiments of the present disclosure, the circuit board 310 further includes a second printed circuit board 312. **In** structure, the second printed circuit board 312 is disposed below the first printed circuit board 311, the main circuit area 301 of the second printed circuit board 312 directly faces the main circuit area 301 of the first printed circuit board 311, the extension area 302 of the second printed circuit board 312 directly faces the extension area 302 of the first printed circuit board 311, and the second metal layer 382 of the upper surface of the second printed circuit board 312 is disposed within the main circuit area 301 of the second printed circuit board 312 only and does not extend to the extension area 302 of the second printed circuit board 312, so as to avoid interference with the printed antenna 330.

In some embodiments of the present disclosure, the printed circuit 340 formed by the portion of the first metal layer 381 of the upper surface of the first printed circuit board 311 within the main circuit area 301 is used to transmit signals, and the second metal layer 382 of the upper surface of the second printed circuit board 312 serves as a ground layer.

In some embodiments of the present disclosure, the circuit board 310 may also include a third printed circuit board 313, the fourth printed circuit board 314 and the fifth printed circuit board 315. In structure, the third printed circuit board 313 is disposed below the second printed circuit board 312, the main circuit area 301 of the third printed circuit board 313 directly faces the main circuit area 301 of the second printed circuit board 312, the extension area 302 of the third printed circuit board 313 directly faces the extension area 302 of the second printed circuit board 312, and the third metal layer 383 of the upper surface of the third printed circuit board 313 is disposed within the main circuit area 301 of the third printed circuit board 313 only and does not extend to the extension area 302 of the third printed circuit board 313.

Similarly, the fourth printed circuit board 314 is disposed below the third printed circuit board 313, the main circuit area 301 of the fourth printed circuit board 314 directly faces the main circuit area 301 of the third printed circuit board 313, the extension area 302 of the fourth printed circuit board 314 directly faces the extension area 302 of the third printed circuit board 313, and the fourth metal layer 384 of the upper surface of the fourth printed circuit board 314 is disposed within the main circuit area 301 of the fourth printed circuit board 314 only and does not extend to the extension area 302 of the fourth printed circuit board 314.

Similarly, the fifth printed circuit board 315 is disposed below the fourth printed circuit board 314, the main circuit area 301 of the fifth printed circuit board 315 directly faces the main circuit area 301 of the fourth printed circuit board 314, the extension area 302 of the fifth printed circuit board 315 directly faces the extension area 302 of the fourth printed circuit board 314, and the fifth metal layer 385 on the upper surface of the fifth printed circuit board 315 is disposed within the main circuit area 301 of the fifth printed circuit board 315 only and does not extend to the extension area 302 of the fifth printed circuit board 315.

In some embodiments of the present disclosure, the third metal layer 383 of the upper surface of the third printed circuit board 313 is used to transmit signals, the fourth metal layer 384 of the upper surface of the fourth printed circuit board 314 serves as a ground layer, and the fifth metal layer 385 of the upper surface of the fifth printed circuit board 315 is used to deliver power, but the present disclosure is not limited thereto.

In some embodiments of the present disclosure, the structure of the circuit board 310 in Fig. 3 can be applicable to or integrated with the structure of the main board 111 of the circuit board 110 in Fig. 1, and the printed circuit 340 can include the first printed wiring 141 and the second printed wiring 142.

In some embodiments of the present disclosure, the structure of the circuit board 310 in Fig. 3 may be applicable to or integrated with the structure of the RF switch board 212 of the circuit board 210 in Fig. 2, and the printed circuit 340 can include the first printed wiring 241 and the second printed wiring 242.

Technical advantages generally achieved by embodiments of the present disclosure include, by designing the printed antennas 130, 230 and 330 on the circuit boards 110, 210 and 310 in the electronic devices of the present disclosure, the risk of stock preparation can be reduced, the assembly efficiency can be increased, and the cost reduction effect can be achieved.

## Claims

1. An electronic device, **characterized by** comprising:
a circuit board (110, 210, 310), wherein a metal layer of an upper surface of the circuit board (110, 210, 310) forms at least one printed antenna (130, 230, 330); and
an antenna signal processing device (120, 220, 320) mounted on the circuit board (110, 210, 310), and the antenna signal processing device (120, 220, 320) is electrically connected to the at least one printed antenna (130, 230, 330) through the circuit board (110, 210, 310).

2. The electronic device of claim 1, **characterized in that** the at least one printed antenna (130, 230, 330) comprises:
a first printed antenna (131, 231) formed on the upper surface of the circuit board (110, 210, 310); and
a second printed antenna (132, 232) formed on the upper surface of the circuit board (110, 210, 310), wherein the first printed antenna (131, 231) and the second printed antenna (132, 232) are positioned at opposite sides of the antenna signal processing device (120, 220, 320).

3. The electronic device of claim 2, **characterized in that** the first printed antenna (131, 231) is physically connected to one side of the antenna signal processing device (120, 220, 320) via a first printed wiring (141, 241) printed on the upper surface of the circuit board (110, 210, 310), and the second printed antenna (132, 232) is physically connected to another side of the antenna signal processing device (120, 220, 320) via a second printed wiring (142, 242) printed on the upper surface of the circuit board (130, 230, 330).

4. The electronic device of claim 1, 2 or 3, **characterized in that** the circuit board (130, 230, 330) is a main board (111, 211), the main board (111, 211) is divided into a main circuit area (101, 301) and an extension area (102, 302), and the at least one printed antenna (130, 230, 330) is formed on the extension area (102, 302).

5. The electronic device of claim 4, **characterized by** further comprising:
a housing (150, 250), wherein the main board (111, 211) is disposed on the housing (150, 250), and a distance between the extension area (102, 302) of the main board (111, 211) and a border of the housing (150, 250) is shorter than a distance between the main circuit area (101, 301) of the main board (111, 211) and the border of the housing (150, 250).

6. The electronic device of claim 1, 2 or 3, **characterized in that** the circuit board (130, 230, 330) is a radio frequency (RF) switch board (112, 212), and the at least one printed antenna (130, 230, 330) is formed on the RF switch board (112, 212).

7. The electronic device of claim 6, **characterized by** further comprising:
a main board (111, 211) electrically connected to the RF switch board (112, 212), and the RF switch board (112, 212) is disposed on the main board (111, 211).

8. An electronic device, **characterized by** comprising:
a circuit board (110, 210, 310) comprising a first printed circuit board (311), wherein a first metal layer (381) of an upper surface of the first printed circuit board (311) forms at least one printed antenna (130, 230, 330); and
an antenna signal processing device (120, 220, 320) mounted on the first printed circuit board (311), and the antenna signal processing device (120, 220, 320) is electrically connected to the at least one printed antenna (130, 230, 330) through the first metal layer (381).

9. The electronic device of claim 8, **characterized in that** the first printed circuit board (381) is divided into a main circuit area (101, 301) and an extension area (102, 302), a portion of the first metal layer (381) of the upper surface of the first printed circuit board (311) is located within the extension area (102, 302) to form the at least one printed antenna (381), and another portion of the first metal layer (381) of the upper surface of the first printed circuit board (311) is located within the main circuit area (101, 301) to form a printed circuit (340).

10. The electronic device of claim 9, **characterized in that** the circuit board (110, 210, 310) further comprises:
a second printed circuit board (312) disposed below the first printed circuit board (311), wherein a main circuit area (101, 301) of the second printed circuit board (312) directly faces the main circuit area (101, 301) of the first printed circuit board (311), an extension area (102, 302) of the second printed circuit board (312) directly faces the extension area (102, 302) of the first printed circuit board (311), and a second metal layer (382) of an upper surface of the second printed circuit board (312) is disposed within the main circuit area (101, 301) of the second printed circuit board (312) only and does not extend to the extension area (102, 302) of the second printed circuit board (312).

11. The electronic device of claim 10, **characterized in that** the printed circuit (340) formed by the portion of the first metal layer (381) of the upper surface of the first printed circuit board (311) within the main circuit area (101, 301) is used to transmit signals, and the second metal layer (382) of the upper surface of the second printed circuit board (312) serves as a ground layer.

12. The electronic device of claim 8, **characterized in that** the circuit board (130, 230, 330) is a main board (111, 211), the main board (111, 211) is divided into a main circuit area (101, 301) and an extension area (102, 302), and the at least one printed antenna (130, 230, 330) is formed in the extension area (102, 302).

13. The electronic device of claim 12, **characterized by** further comprising:
a housing (150, 250), wherein the main board (111, 211) is disposed on the housing (150, 250), and a distance between the extension area (102, 302) of the main board (111, 211) and a border of the housing (150, 250) is shorter than a distance between the main circuit area (101, 301) of the main board (111, 211) and the border of the housing (150, 250).

14. The electronic device of claim 8, 9, 10 or 11, **characterized in that** the circuit board (130, 230, 330) is a radio frequency (RF) switch board (112, 212), and the at least one printed antenna (130, 230, 330) is formed on the RF switch board (112, 212).

15. The electronic device of claim 14, **characterized by** further comprising:
a main board (111, 211) electrically connected to the RF switch board (112, 212), and the RF switch board (112, 212) is disposed on the main board (111, 211).
